**Europäisches Patentamt**

**European Patent Office**

**Office européen des brevets**

(19)

(11) Veröffentlichungsnummer: **0 308 584**
**A1**

## (12) EUROPÄISCHE PATENTANMELDUNG

(21) Anmeldenummer: **88108599.7**

(22) Anmeldetag: **30.05.88**

(51) Int. Cl.⁴: **H05K 7/14**

(30) Priorität: **25.09.87 DE 3732346**

(43) Veröffentlichungstag der Anmeldung:
**29.03.89 Patentblatt 89/13**

(84) Benannte Vertragsstaaten:
**DE ES FR GB IT SE**

(71) Anmelder: **Messerschmitt-Bölkow-Blohm**
**Gesellschaft mit beschränkter Haftung**
**Robert-Koch-Strasse**
**D-8012 Ottobrunn(DE)**

(72) Erfinder: **Fischer, Manfred**
**An der Ottosäule**
**D-8012 Ottobrunn(DE)**

(54) **Spannelement für Elektronik-Karten.**

(57) Die Erfindung bezieht sich auf ein Spannelement für Elektronik-Karten mit einem Trägererlement und einem an diesem verbundenen Klemmteil, das nicht nur einen extrem geringen Raumbedarf erfordert, sondern auch verschieden große Elektronik-Karten aufnehmen kann. Ein Ausführungsbeispiel ist beschrieben und in den Figuren der Zeichnung dargestellt.

FIG. 2

EP 0 308 584 A1

## Spannelement für Elektronik-Karten

Die Erfindung bezieht sich auf ein Spannelement für Elektronik-Karten mit einem Trägerelement und einem an diesem mittels eines Spannelementes verbundenen Klemmteil.

Durch die DE-PS 29 20 468 ist ein solches Spannelement bekannt geworden. Dieses setzt sich im wesentlichen aus zwei Flachstangen zusammen, zwischen denen eine Vielzahl von schrägstehenden Lenkern angeordnet sind, die von einer dieser Stangen über eine Längsverschiebung eine Vergrößerung des Abstandes zur anderen Stange erzielen und damit die Möglichkeit schaffen, unterschiedlich starke Leiterplatten halten und klemmen zu können. Allerdings sind bei dieser vorgeschlagenen Lösung nur Platten einer bestimmten Flächengröße zu klemmen, denn diese sind für spezielle Nuten in dem Gehäuse ausgelegt. Ein weiterer Nachteil dieser Anordnung ist, daß sie nur für Nuten oder ähnliche Einschübe verwendbar sind die auch die Verstelleinrichtung zur Klemmung der Leiterplatten tragen. Das Spannelement kann also nicht als komplette Baueinheit unabhängig von der Gehäusekonzeption verwendet werden.

Eine ähnliche Einrichtung ist aus der GB-PS 2 103 020 bekannt geworden. Auch hier wird das Spannelement in vorgefertigte Gehäuseschlitze oder Nuten eingebracht und das Spannelement selbst besteht aus zwei sägezahnartig miteinander in Wirkverbindung stehenden Stangen, die durch Schraubeneinstellung gegeneinander verschoben werden und so Leiterplatten unterschiedlicher Stärke klemmen können. Auch diese Ausführungsform ist an bestimmte Gehäuseschlitze zum sich Abstützen gebunden und kann ebenfalls nicht als geschlossenen Baueinheit unabhängig von der Gehäuse- und Kartenkonfiguration eingesetzt werden.

Der vorliegenden Erfindung liegt die Aufgabe zugrunde, ein Spannelement zu schaffen, das nicht nur einen extrem geringen Raumbedarf erfordert, sondern auch verschieden große Elektronikkarten aufnehmen kann, also nicht an eine bestimmte Kartengröße gebunden ist.

Diese Aufgabe wird durch die im Anspruch 1 niedergelegten Maßnahmen erfüllt. In den Unteransprüchen sind Ausgestaltungen und Weiterbildungen angegeben und in der nachfolgenden Beschreibung ist ein Ausführungsbeispiel beschrieben und in den Figuren der Zeichnung dargestellt. Es zeigen:

Fig. 1 eine perspektivische Ansicht des zu einer Baueinheit zusammengefaßten lager- und transportfähigen Spannelements,

Fig. 2 einen Längsschnitt durch die Ausführungsform gemäß Fig. 1 mit strichpunktiert dargestellter Klemmstellung,

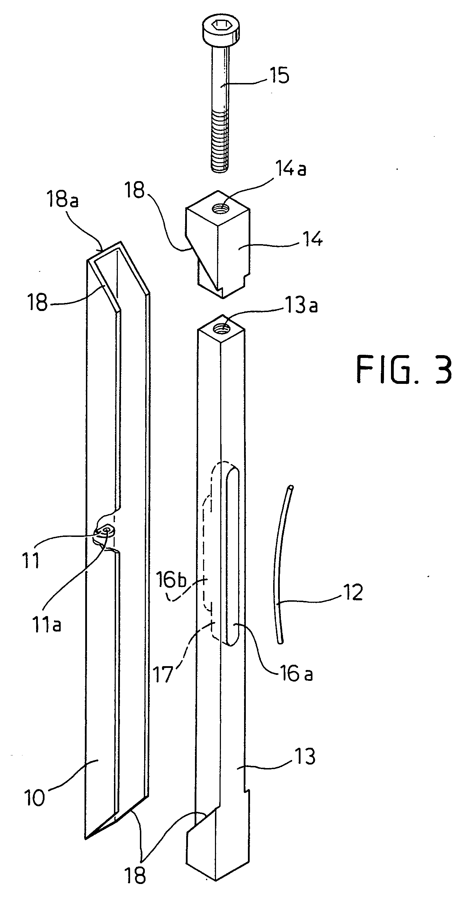

Fig. 3 eine Explosionszeichnung der Einzelteile des zu einer Baueinheit zusammengefaßten Spannelements gemäß den Figuren 1 und 2.

Fig. 4 eine Ansicht eines speziellen Ausführungsbeispiels.

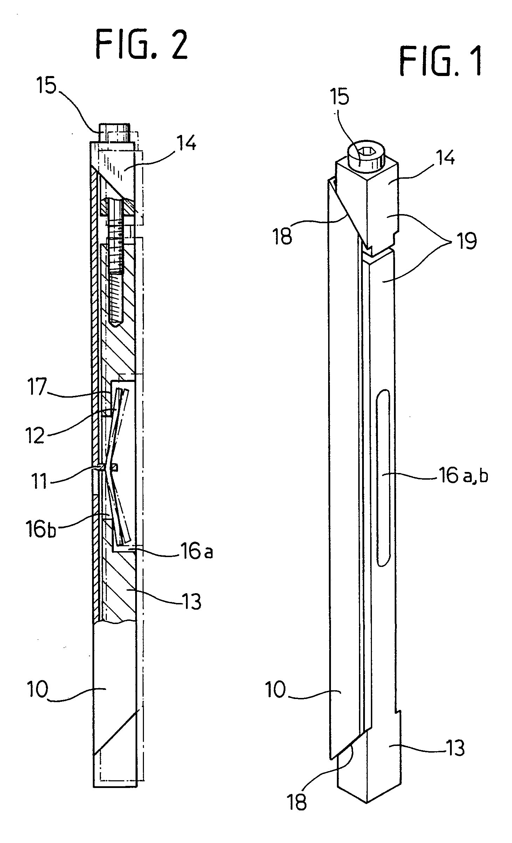

Die in den Figuren 1 und 2 gezeigte Konfiguration des vorgeschlagenen Spannelements setzt sich aus einer u-förmigen Blechschiene, die als Führungsschiene 10 bezeichnet ist, und einem sogenannten Klemmelement 13 zusammen. Die Führungsschiene 10 ist an ihren beiden Enden mit je einer Schräge 18 versehen und weist ihrem Zentral- oder Schwerpunkt eine Halteöse 11 auf. Diese kann beispielsweise aus einem aus der Grundfläche der Führungsschiene 10 ausgestanzten und aufgebogenen Lappen bestehen, in den gleichzeitig mit dem Ausstanzen auch das Aufnahmeloch 11a für ein Federblättchen 12 ausgestanzt wird. In diese Führungsschiene 10 wird nun das sogenannte Klemmelement eingesetzt und zwar so, daß einmal die Schrägen 18 von Führungsschiene und Klemmelement aneinander zu liegen kommen.

Das Klemmelement 13 ist, wie vorstehend erwähnt an seinen Endpartien ebenfalls mit Schrägen 18 versehen, die sich daraus ergeben, daß der Teil, der längenmäßig der Führungsschiene 10 entspricht zu einem quadratischen Querschnitt angefräst worden ist, der dem Innendurchmesser der Führungsschiene 10 entspricht. Die mit den Schrägen versehenen beiden Endpartien dagegen weisen einen Außendurchmesser auf, der demjenigen der Führungsschiene entspricht. Dieses so gefertigte Klemmelement 13 wird nun in seinem Mittelteil mit einem Langloch 16a, 16b versehen, das so gebildet wird, daß die Länge des zur Führungsschiene gerichteten Teils kürzer ist als die Länge des zur Platine oder Karte gerichteten Teils. Durch diese Ausgestaltung ergibt sich nun ein um einen bestimmten Betrag erhöhtes Auflager 17, auf dem die Enden des durch die Halteöse 11 gezogenen Federblättchens 12 zu liegen kommen und somit die Führungsschiene 10 und das Klemmelement miteinander so verbinden, daß das Klemmelement 13 unter einer bestimmten Vorspannung gehalten ist.

Das eine Ende des Klemmelements 13 wird abgeschnitten und mit einem Gewindebohrloch 14a versehen, das sich im Klemmelement 13 als Aufnahmebohrung 13a fortsetzt. Dieses abgetrennte Endstück dient als Verstellblock 14, welcher im Zusammenhang mit einer Verstellschraube 15 zur Platinen- oder Kartenklemmung durch Schraubendrehung das Klemmelement 13 auf den Schrägen 18 je nach Drehrichtung verschiebt.

Da das Spannelement gleichzeitig noch die Funktion einer guten Wärmeableitung erfüllen soll, wird vorgeschlagen, daß die Führungsschiene und das Klemmelement aus einem gut wärmeleitenden Material gefertigt sind. Für die gute Wärmeableitung genügt aber auch ein gut wärmeleitendes Plättchen oder Wärmeleitgitter, das zwischen Spannelement und Gehäuse gelegt bzw. angeordnet wird. Ein wesentlicher Punkt der vorgeschriebenen Konfiguration ist, daß das Spannelement unabhängig von der Karten- oder Platinengröße verwendbar ist. Hierzu ist die Ausbildung so geschaffen, daß die Klemmfläche 19 von Klemmelement 13 und Verstellblock eine plane Ebene bilden. Dadurch können problemlos Karten aufgenommen und gehalten werden, die länger oder auch kleiner als das Spannelement sind. Dieses kann in jedem Gehäuse entweder mit Schrauben, Klammern etc. vorzugsweise aber durch Klebung angeordnet werden.

Die Klemmfunktion des Spannelementes für Elektronik-Karten etc. in Gehäuseschlitzen kann aber auch in umgekehrter Form erfolgen. Hier wird dann das Klemmelement 13 durch Verklebung oder Verschraubung im Gehäuseschlitz befestigt und die plane Grundfläche 18a der u-förmigen Führungsschiene 10 preßt nun die Platine etc. an die Gehäuseschlitzwand.

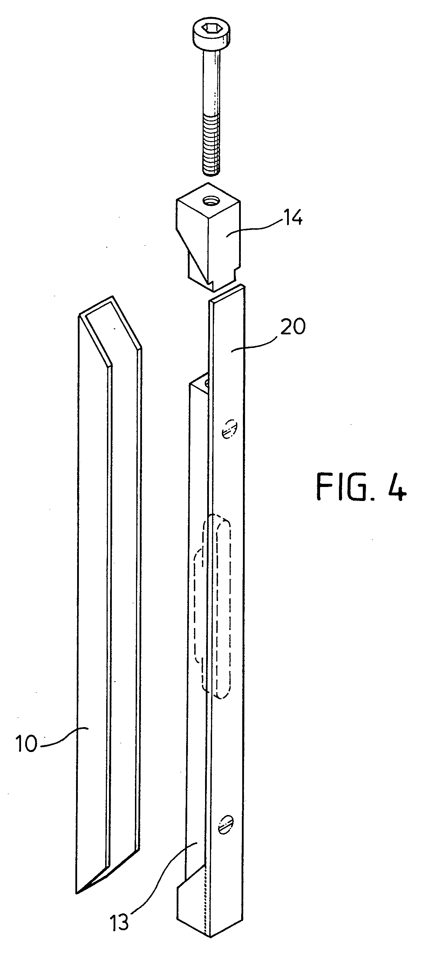

Für diese Anwendungsform ist in der Figur 4 der Zeichnung eine spezielle Ausgestaltung des Spannelementes vorgeschlagen. Diese unterscheidet sich von den übrigen Formen dadurch, daß das Klemmelement an seiner sogenannten Klemmfläche 19, die in dem vorliegenden Fall nun als Anlagefläche im Gehäuseschlitz dient, entweder mit einer zusätzlichen Platte 20 versehen ist, die in ihrer Länge dem Verstellbereich des Verstellblockes 14 entspricht, oder das Klemmelement 13 ist in seiner Länge entsprechend dem vorgenannten Verstellbereich ausgeführt und weist in diesem Verstellbereich eine Ausfräsung für den Verstellblock 14 und seine Verstellbewegung auf. Durch diese Ausgestaltung dient die Führungsschiene 10 als Platinenandruck- bzw. -spannteil. Die durch die Platte 20 oder die Ausfräsung geschaffene Gleit- und Stützbahn für den Verstellblock 14 verhindert durch die Schraubbewegungen möglicherweise auftretende Biegemomente. Die Platte 20 kann entweder angeschweißt, angeschraubt oder direkt an das Klemmelement angegossen sein.

Der besondere Vorteil des vorbeschriebenen Spannelementes ist, daß sogenannte Kartenleerplätze schon mit dem Spannelement versehen werden können und durch die Verstellmöglichkeit von Führungsschiene 10 und Klemmelement 13 mittels des Verstellblockes 14 ist eine Verspannung gegeben, die eine vibrationsfreie, geräuschfreie Lagerung des Spannelementes in den Schlitzen des Gehäuses auch ohne Elektronik-Karte bzw. Platine gewährleistet. Ein weiterer Vorteil des vorgeschlagenen Spannelementes ist es, daß das Gußgehäuse für die Aufnahme der Elektronik-Karten und die Gehäuseschlitze unbearbeitet bleiben können.

## Ansprüche

1. Spannelement für Elektronik-Karton mit einem Trägerelement und einem an diesem mittels eines Spannelementes verbundenen Klemmteil, **dadurch gekennzeichnet,** daß das Spannelement als komplette lager- und transportfähige Baueinheit ausgebildet ist, wobei das Trägerelement als u-förmige Führungsschiene (10) konzipiert ist und über eine in ihrem Zentralpunkt angeordnete Halteöse (11) und einem Federblättchen (12) das Klemmelement (13) aufnimmt, welches mittels eines Verstellblockes (14) und einer Stellschraube (15) in ihrer Spannkraft einstellbar ist und daß kie Klemmfläche (19) von Klemmelement (13) und Verstellblock (14) eine plane Ebene bilden.

2. Spannelement nach Anspruch 1, **dadurch gekennzeichnet,** daß das Klemmelement (13) einen quadratischen Querschnitt aufweist, der in seinem Mittelteil der Länge und dem Innendurchmesser der u-förmigen Führungsschiene (10) und an seinem beiden Endpartien dem Außendurchmesser der Führungsschiene (10) angepaßt ist.

3. Spannelement nach einem der Ansprüche 1 oder 2, **dadurch gekennzeichnet,** daß das Klemmelement (13) in seinem Mittelteil mit einem Langloch (16a, 16b) versehen ist, das auf der der Führungsschiene (10) zugewandten Fläche in seiner Länge kürzer und auf der Klemmseite (19) länger ist, so daß sich ein Auflager (17) für das Federplättchen (12) ergibt.

4. Spannelement nach einem der Ansprüche 1 bis 3, **dadurch gekennzeichnet,** daß Führungsschiene (10) und Klemmelement (13) miteinander in schrägen Flächen (18) geführt sind.

5. Spannelement nach einem der Ansprüche 1 bis 4, **dadurch gekennzeichnet,** daß die Führungsschiene (10) und das Klemmelement (13) aus einem gut wärmeleitenden Werkstoff gebildet sind.

6. Spannelement nach einem der Ansprüche 1 bis 5, **dadurch gekennzeichnet,** daß die Klemmfläche (19) des Klemmelementes (13) durch Klebung oder Verschraubung als Anlagefläche in dem Schlitz des Gehäuses dient und die Platine bzw. Elektronik-Karte durch die Führungsschiene (10) angepreßt und gehalten wird.

7. Spannelement nach einem der Ansprüche 1 bis 6, **dadurch gekennzeichnet,** daß das Klemmelement (13) über den Verstellbereich des Verstellblockes (14) eine Lagerplatte (20) als Gleit- und Stützbahn für diesen Verstellblock (14) aufweist, die auf dem Klemmelement (13) aufgeklebt, verschraubt oder direkt angegossen ist.

# FIG. 2

# FIG. 1

FIG. 3

10 355

14

20

# FIG. 4

10

13

10 355

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-4 480 287 (JENSEN)<br>* Spalte 4, Zeilen 17-55 *<br>--- | 1-2,4-7 | H 05 K 7/14 |
| Y | US-A-4 354 770 (BLOCK)<br>* Spalte 2, Zeilen 11-44 *<br>--- | 1-2,4-7 | |
| A | US-A-3 767 058 (BARLOW)<br>* Spalte 3, Zeile 49 - Spalte 4, Zeile 2 *<br>--- | 1-2 | |
| A,D | DE-A-2 920 468 (LICENTIA PATENT VERWALTUNG)<br>--- | | |
| A | GB-A-2 103 020 (MARCONI AVIONICS LTD)<br>----- | | |

RECHERCHIERTE SACHGEBIETE (Int. Cl.4)

H 05 K

Der vorliegende Recherchenbericht wurde für alle Patentansprüche erstellt

| Recherchenort | Abschlußdatum der Recherche | Prüfer |
|---|---|---|
| DEN HAAG | 20-08-1988 | TOUSSAINT F.M.A. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
.......................................................................................................
& : Mitglied der gleichen Patentfamilie, übereinstimmendes
    Dokument

EPO FORM 1503 03.82 (P0403)